# EUROPEAN PATENT APPLICATION

(11) **EP 3 012 344 A1**
(43) Date of publication of application: **27.04.2016**
(21) Application number: 15002952.8
(22) Date of filing: 16.10.2015
(51) Int. Cl.: C23C 14/02, C23C 14/14, C23C 14/30, C23C 14/50, C23C 14/54, C23C 14/22, B82Y 40/00

(54) **METHOD AND APPARATUS FOR PRODUCING NANOSTRUCTURES, AND SUBSTRATE STRUCTURE INCLUDING NANOSTRUCTURES**

(30) Priority: 21.10.2014 JP 2014214096
(71) Applicant: Kyoto University, Sakyo-ku Kyoto-shi Kyoto 606-8501 (JP); Hitachi, Ltd., Tokyo 100-8280 (JP)
(72) Inventor: Tanie, Hisashi, Tokyo, 100-8280 (JP); Sumigawa, Takashi, Kyoto, 606-8501 (JP); Kitamura, Takayuki, Kyoto, 606-8501 (JP)
(74) Representative: Strehl Schübel-Hopf & Partner

(57) **Abstract**

Provided are a method and an apparatus for producing nanostructures. The method and the apparatus can form the nanostructures having fine dimensions from a wider variety of materials. Also provided is a substrate structure including nanostructures formed from a material that is industrially widely applicable. A method forms a plurality of nanostructures on a flat surface of a substrate. The method includes the step a) of evaporating a main material for the nanostructures onto the flat surface of the substrate. In the step a), the substrate is controlled to have an absolute temperature equal to or lower than 0.25 time the melting point (absolute temperature) of the main material for the nanostructures. This enables the formation of fine nanostructures having a desired shape from a desired material.

## Description

### BACKGROUND OF THE INVENTION

### Field of the Invention

The present invention relates to a method and an apparatus for producing nanostructures on or over a substrate; and a substrate structure including a substrate and nanostructures disposed on or over the substrate.

### Description of Prior Art

Nanostructures (nanoscale structures) include any of metal materials and various organic and inorganic materials and have nanometer-order scale dimensions. Such nanostructures are increasingly examined. The nanostructures differ in properties from corresponding bulk materials, even when including an identical material, and are examined so as to be applied typically to electronic devices.

Known techniques for producing a plurality of nanostructures as a flat plane are exemplified by dynamic oblique deposition, DC plasma-enhanced chemical vapor deposition, hydrothermal crystallization of colloidal precursors, template-synthesis, molecular beam epitaxy, and reactive pulsed laser deposition, as described by Takayuki Kitamura et al. in "FRACTURE NANOMECHANICS", PAN STANFORD PUBLISHING (2011), ISBN 978-981-4241-83-0.

U.S. Unexamined Patent Application Publication No. 20100328896 describes a technique for forming nanosprings by the dynamic oblique deposition, where the nanosprings include copper and have a spring diameter of about ten nanometers to about several micrometers.

Japanese Patent No. 4938365 describes a method for producing a nanoscale three-dimensional structure using carbonaceous dies. Japanese Unexamined Patent Application Publication (JP-A) No. 2014-101512 describes a technique for producing nanostructures by self-assembly.

Upon production of a plurality of nanostructures as a flat plane, structures to be formed and materials to be used have limitations differing from a production method to another. The dynamic oblique deposition is suitable for self-standing columnar structures that have a helical shape or a zigzag shape, where such columnar structures are hardly producible by production methods using a template or a die. However, conventional techniques using dynamic oblique deposition are limited in usable materials and in dimensions (sizes) of producible nanostructures. Specifically, the materials usable for the production of nanostructures are limited typically to silicon and tantalum oxides. The conventional techniques using dynamic oblique deposition therefore fail to produce nanostructures having fine dimensions in terms typically of a diameter of less than 100 nm from materials that are widely industrially applicable. The materials are exemplified by copper and aluminum.

### SUMMARY OF THE INVENTION

Under these circumstances, the present invention has an object to provide a method and an apparatus for producing nanostructures, by which a wider variety of materials are applicable to form the nanostructures, and by which the nanostructures are producible with fine dimensions. The present invention has another object to provide nanoscale-structure-containing substrate structures from materials that.are widely industrially applicable.

To achieve the objects, a production method according to the present invention includes a first step of evaporating a main material for the nanostructures onto a flat surface of a substrate to form a plurality of the nanostructures on or over the flat surface of the substrate. In the first step, the substrate is controlled to have an absolute temperature equal to or lower than 0.25 time the melting point (absolute temperature) of the main material for the nanostructures.

To achieve the objects, a production apparatus according to the present invention includes a vacuum chamber, a crucible, an electron gun, a stage, a cooling unit, a heating unit, a temperature sensor, and a controller. In the vacuum chamber, nanostructures are to be formed. The crucible is disposed in the vacuum chamber, and a material is to be placed in the crucible. The electron gun is disposed in the vacuum chamber and is configured to apply electron beams to the material in the crucible so as to evaporate the material. The stage is disposed in the vacuum chamber so as to face the crucible, and bears a member (substrate) on or over which the evaporated material is deposited. The stage is pivotally supported and is arranged so as to face the crucible at a variable angle. The cooling unit cools the stage. The heating unit heats the stage. The temperature sensor detects the temperature of the stage. The controller operates the cooling unit and the heating unit based on the temperature detected by the temperature sensor so as to control the temperature of the stage.

In addition, a substrate structure according to the present invention includes a substrate and a plurality of nanostructures. The substrate has a flat surface. The plurality of nanostructures are disposed vertically on or over the flat surface. The nanostructures have a diameter (wire diameter) of less than 100 nm and include a main material having a melting point equal to or lower than the melting point of copper.

The production method according to the present invention controls the substrate to have an absolute temperature equal to or lower than 0.25 time the melting point (absolute temperature) of the main material for the nanostructures. The production method can thereby form fine nanostructures having a desired shape from a desired material.

The production apparatus according to the present invention can control the substrate temperature by heating and cooling of the stage so as to form desired nanostructures. The production apparatus can thereby form fine nanostructures having a desired shape from a desired material.

The substrate structure according to the present invention can be provided as a substrate structure including fine nanostructures having a relatively low melting point. The substrate structure allows nanostructures to be industrially applicable more widely.

Other objects, configurations, and advantageous effects will be apparent from the description of embodiments below.

### BRIEF DESCRIPTION OF THE DRAWINGS

Fig. 1 illustrates the relationship between the melting point of a main material for nanostructures and the formation temperature to form the nanostructures;
Fig. 2 illustrates an apparatus for producing nanostructures according to a first embodiment of the present invention;
Fig. 3A illustrates a method for producing nanostructures using the production apparatus illustrated in Fig. 2;
Fig. 3B illustrates the method for producing nanostructures using the production apparatus illustrated in Fig. 2;
Fig. 3C illustrates the method for producing nanostructures using the production apparatus illustrated in Fig. 2;
Fig. 3D illustrates the method for producing nanostructures using the production apparatus illustrated in Fig. 2;
Fig. 4 illustrates shapes of nanostructures formed using nickel as a main material;
Fig. 5 illustrates nanostructures according to a second embodiment of the present invention;
Fig. 6 illustrates nanostructures according to a third embodiment of the present invention;
Fig. 7 illustrates nanostructures according to a fourth embodiment of the present invention;
Fig. 8A illustrates a method for producing the nanostructures according to the fourth embodiment;
Fig. 8B illustrates the method for producing the nanostructures according to the fourth embodiment;
Fig. 8C illustrates the method for producing the nanostructures according to the fourth embodiment;
Fig. 8D illustrates the method for producing the nanostructures according to the fourth embodiment;
Fig. 8E illustrates the method for producing the nanostructures according to the fourth embodiment;
Fig. 9 illustrates nanostructures according to a fifth embodiment of the present invention;
Fig. 10A illustrates a method for producing the nanostructures according to the fifth embodiment;
Fig. 10B illustrates the method for producing the nanostructures according to the fifth embodiment;
Fig. 10C illustrates the method for producing the nanostructures according to the fifth embodiment;
Fig. 11A illustrates nanostructures, and a production method of the nanostructures, according to a sixth embodiment of the present invention;
Fig. 11B illustrates the nanostructures, and the production method of the nanostructures, according to the sixth embodiment of the present invention;
Fig. 11C illustrates the nanostructures, and the production method of the nanostructures, according to the sixth embodiment of the present invention;
Fig. 12A illustrates helical nanostructures;
Fig. 12B illustrates zigzag nanostructures;
Fig. 12C illustrates columnar nanostructures;
Fig. 12D illustrates oblique columnar nanostructures;
Fig. 12E illustrates helical nanostructures each having a varying helical diameter;
Fig. 12F illustrates nanostructures including multiple layers; and
Fig. 13 illustrates melting points and temperatures to be controlled of major materials.

### DETAILED DESCRIPTION OF PREFERRED EMBODIMENTS

The present invention will be illustrated with reference to some embodiments and the attached drawings.

### First Embodiment

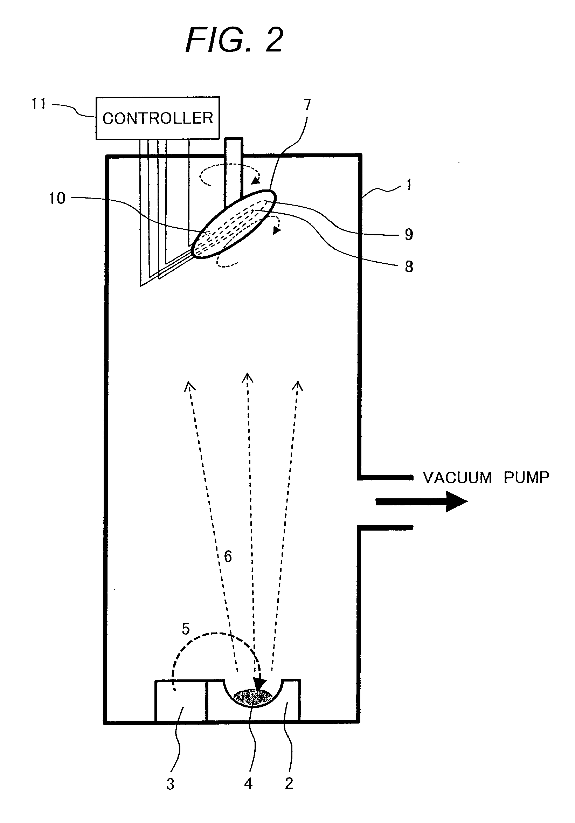

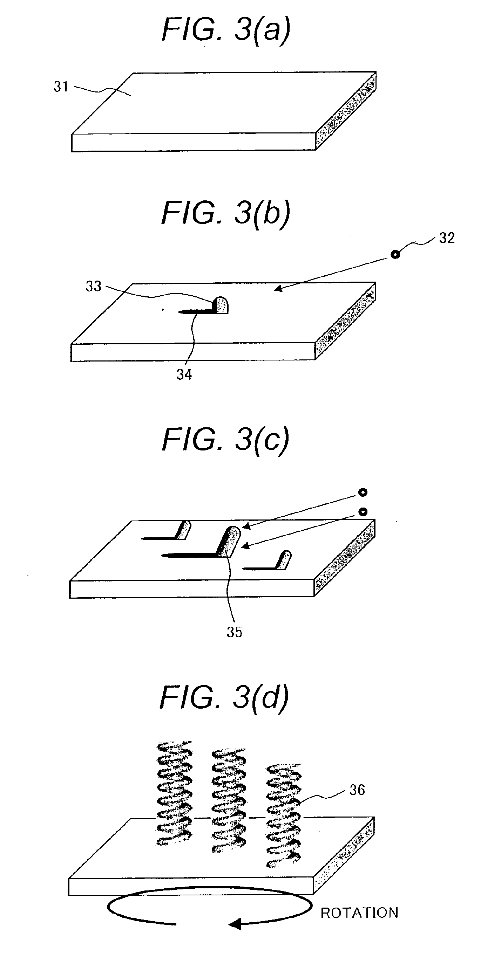

Fig. 2 illustrates a nanostructure production apparatus according to the first embodiment of the present invention. Figs. 3A, 3B, 3C, and 3D illustrate a production method for forming nanostructures using the production apparatus illustrated in Fig. 2.

The production apparatus illustrated in Fig. 2 forms nanostructures by dynamic oblique deposition. The production apparatus according to the first embodiment includes a vacuum chamber 1, a crucible 2, an electron gun 3, and a stage 7. The vacuum chamber 1 can be evacuated approximately to a vacuum using a vacuum pump (not shown). The crucible 2, the electron gun 3, and the stage 7 are disposed in the vacuum chamber 1. The stage 7 faces the crucible 2. The stage 7 includes a mechanism that holds the stage at a certain angle with respect to the crucible 2 and changes the angle. The stage 7 further includes a rotating mechanism that rotates of the stage 7 around rotating axis oriented in a direction from the stage 7 to the crucible 2, and a rotating mechanism that rotates a plane of the stage 7. When a material 4 to form nanostructures is placed in the crucible 2, the electron gun 3 emits and applies an electron beam 5 to the material. The applied electron beam 5 allows the material 4 to be evaporated and to form a vapor flow 6. The vapor flow 6 reaches, and is deposited on, the stage 7 to form a nanostructure.

A substrate 31 having a flat surface (Fig. 3A) has been secured to the surface of the stage 7 in advance. An atom 32 evaporated from the material 4 reaches, and is deposited on, the surface of the substrate 31. The atom 33 deposited on the surface of the substrate 31 casts a shadow 34 on the surface of the substrate 31 (Fig. 3B). Once the shadow 34 cast by the deposited atom forms, the evaporated atom 32 is deposited neither on a shaded area of the deposited atom 33 nor on the shadow 34 cast by the deposited atom, but deposited on a front surface of the deposited atom 33 alone, where the front surface faces the evaporated atom 32. The evaporated atom 32 is deposited in the above manner to form oblique columns 35 (Fig. 3C). The stage 7 may be rotated in-plane at a constant speed during the deposition of the atom 32. In this case, the shaded area and the shadow 34 cast by the deposited atom 33 are oriented in a direction varying with the in-plane rotation of the stage 7. This process forms a plurality of helical, self-standing nanostructures 36 on the substrate 31. As used herein the term "nanostructure" refers to a structure having a diameter (wire diameter) of less than 100 nm. The nanostructures having any helical shape can be produced by controlling conditions such as the stage angle and rotation speed.

Assume that the evaporated atom 32 is deposited on the substrate or on the atom 33 deposited on the substrate so as to produce appropriate nanostructures by the production method. In this case, the evaporated atom 32 should be deposited on track of the vapor flow without turning around the shaded area and entering the shadow 34 cast by the deposited atom. According to the first embodiment, the temperature of the substrate 31 is controlled to be equal to or lower than a predetermined temperature. The control prevents the evaporated atom 32 from having such energy as to turn around the shaded area and enter the shadow 34 cast by the deposited atom when the evaporated atom 32 approaches the substrate or the atom 33 deposited on the substrate.

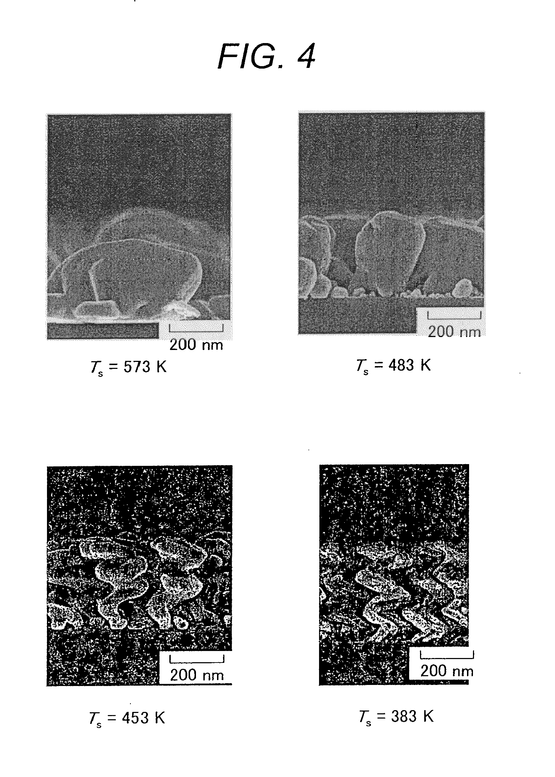

Fig. 4 illustrates shapes of nanostructures formed at different substrate temperatures using nickel as a main material. These nanostructures are produced at the different substrate temperature while controlling the rotation of the substrate so as to give nanostructures having helical shapes. Fig. 4 depicts photomicrographic representations of the formed nanostructures under observation with a scanning electron microscope (SEM), in which Ts represents the substrate temperature.

At a substrate temperature Ts of 573K (absolute temperature, hereinafter the same), the material nickel does not form nanostructures with a desired helical shape, but forms a plurality of nickel blocks having a diameter of about 300 nm on the substrate 31. Also at a substrate temperature Ts of 483K, the material nickel does not form nanostructures with a desired helical shape, but forms a plurality of nickel blocks having a diameter of about 200 nm. At a substrate temperature Ts of 453K, the material forms nanostructures with a shape having a wire diameter of about 50 nm at the bottom portion and resembling a helical shape, but having an increasing diameter with growth. At a substrate temperature Ts of 383K, the material forms nanostructure with a desired, clear helical shape. The nanostructures each have a diameter (wire diameter) of about 20 nm at the bottom portion, where the diameter less increases with growth. The material nickel has a melting point of 1725K. The ratio of the substrate temperature Ts of 453K at which nanostructure with an approximate helical shape can be formed to the melting point is 0.26. The ratio of the substrate temperature Ts of 383K at which a clear helical shape can be formed to the melting point is 0.22. Specifically, assume that the absolute temperature of the substrate 31 is controlled to be equal to or lower than 0.25 time the melting point (absolute temperature) of nickel, where nickel is a main material to form the nanostructures. This can form fine nanostructures having a diameter of less than 100 nm and having a desired helical shape.

As illustrated in Fig. 2, the production apparatus according to the first embodiment includes a cooling unit 8 and a heating unit 9 both in the stage 7 so as to control the temperature Ts of the substrate 31 within a wide temperature range as in Fig. 4. The cooling unit 8 uses liquid nitrogen as a coolant. The heating unit 9 uses an electric heater. The production apparatus further includes a thermocouple 10 disposed on the backside of the stage 7. The thermocouple 10 is a temperature sensor to measure the temperature of the stage 7. The production apparatus further includes a controller 11 that operates the cooling unit and the heating unit based on the temperature of the stage 7 detected by the thermocouple 10. The controller 11 controls the substrate temperature at a predetermined temperature or within a predetermined temperature range. This enables the formation of fine nanostructures having a desired shape from a desired material.

The production apparatus according to the first embodiment employs a cooling unit that uses liquid nitrogen as a coolant. However, the production apparatus may employ any cooling unit which is not limited to this and is exemplified by a chiller. The use of the chiller eases the temperature control. The use of liquid nitrogen as a coolant can lower the lower limit of the temperature to which the substrate can be cooled. The lowered lower limit of the temperature range can widen the temperature range that is controllable.

The resulting nanoscale-structure-containing substrate structure formed with the production apparatus by the production method as described above includes fine nanostructures having a diameter of 100 nm and includes nickel, where nickel has a relatively low melting point and is industrially useful. The nanoscale-structure-containing substrate structure is applicable to a variety of industrial areas such as electronic devices.

### Second Embodiment

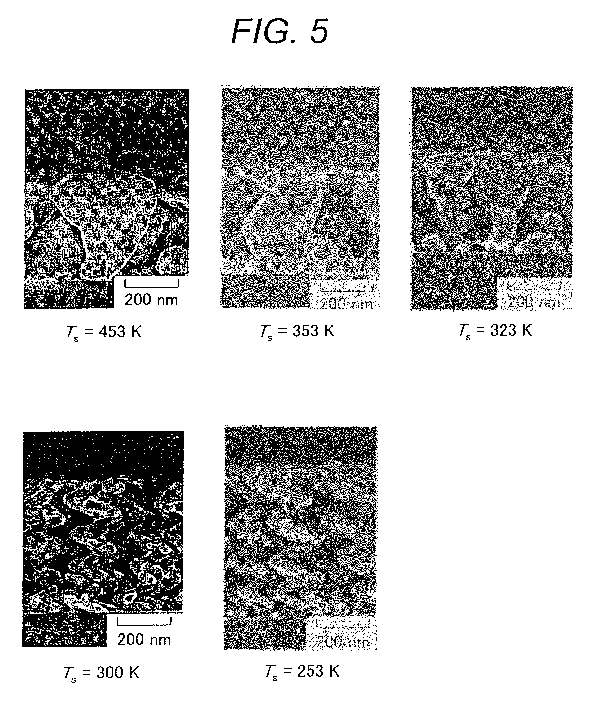

Fig. 5 illustrates nanostructures according to the second embodiment of the present invention. The second embodiment differs from the first embodiment as follows. The first embodiment uses nickel as the main material for the nanostructures. In contrast, the second embodiment uses copper as the main material. Fig. 5 illustrates shapes of nanostructures formed at different substrate temperatures in a similar manner to the first embodiment, except for using copper as the main material. Specifically, the nanostructures are formed while controlling the rotation of the substrate so as to allow the nanostructure to have a helical shape. Fig. 5 depicts photomicrographic representations of the formed nanostructures under observation with an SEM, as with Fig. 4.

The material copper does not form nanostructures with a desired helical shape at substrate temperatures Ts of 453K and 353K, but forms copper blocks having a diameter of about 200 nm on the substrate 31. At a substrate temperature Ts of 323K, the material forms nanostructures with a shape having a diameter of about 50 nm at the bottom portion and resembling a columnar, helical shape. However, the structures have an increasing diameter with growth and have a large diameter of about 200 nm at a growth of about 300 nm from the bottom portion. The material forms nanostructures with a desired, clear helical shape at a substrate temperature Ts of 300K. The nanostructures have a diameter of about 20 nm at the bottom portion, where the wire diameter less increases with growth. The material also forms nanostructures with a desired, clear helical shape at a lower substrate temperature Ts of 253K. The material copper has a melting point of 1306K. The ratio of the substrate temperature Ts of 323Kat which the material forms nanostructures with an approximately helical shape to the melting point is 0.25. The ratios of the substrate temperatures Ts of 300K and 253K at which the material forms nanostructures with a desired, clear helical shape to the melting point are respectively 0.23 and 0.19.

The material nickel begins forming nanostructures with a helical shape at a substrate temperature Ts of 453K in the nickel nanostructures according to the first embodiment. In contrast, the material copper begins forming nanostructures with a helical shape at a substrate temperature Ts of 323K in the copper nanostructures according to the second embodiment. These demonstrate that the substrate temperature to be controlled varies from a material to another. In contrast, the ratios between the substrate temperatures and the melting points of the materials are focused herein. The ratio of the substrate temperature Ts at which the material begins forming nanostructures with a helical shape to the material melting point is 0.26 in the nickel nanostructures according to the first embodiment. The ratio of the substrate temperature Ts at which the material begins forming nanostructures with a helical shape to the material melting point is 0.25 in the copper nanostructures according to the second embodiment. These demonstrate that the substrate temperature may be controlled so as to give an approximately same ratio to the material melting point regardless of the kind of the material.

Assume that a material for nanostructures is evaporated onto a substrate by dynamic oblique deposition without the temperature control. In this case, the substrate receives the energy of atoms derived from the material and has an elevating temperature. In contrast, according to the second embodiment, the material is evaporated onto the substrate by dynamic oblique deposition while cooling the substrate to control the substrate temperature Ts to be 323K. Thus, the second embodiment can give fine, helical, copper nanostructures.

As described above, the second embodiment controls the absolute temperature of the substrate 31 to be equal to or lower than 0.25 time the melting point (absolute temperature) of copper, where copper is a main material for the nanostructures. The control can give fine nanostructures that have a diameter of less than 100 nm and have a desired helical shape. The substrate structure according to the second embodiment includes fine nanostructures having a diameter of less than 100 nm and including copper, where copper has a relatively low melting point and is industrially useful. The substrate structure is thereby applicable to a variety of industrial areas such as electronic devices.

### Third Embodiment

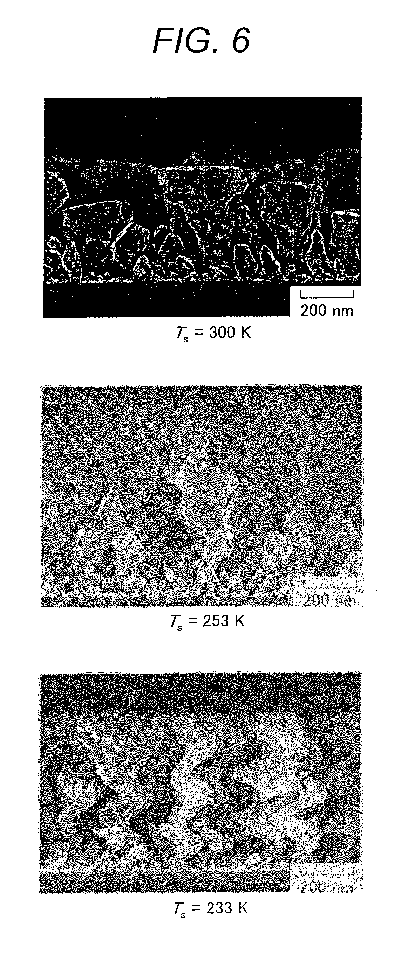

Fig. 6 illustrates nanostructures according to the third embodiment of the present invention. The third embodiment differs from the first and second embodiments as follows. The first embodiment and the second embodiment respectively use nickel and copper as the main material for the nanostructures; whereas the third embodiment uses aluminum as the main material.

Fig. 6 illustrates shapes of nanostructures formed at different substrate temperatures in a similar manner to the first and second embodiments, except for using aluminum as the main material. Specifically, the nanostructures are formed while controlling the rotation of the substrate so as to allow the nanostructures to have a helical shape. Fig. 6 depicts photomicrographic representations of the formed nanostructures under observation with an SEM, as with Figs. 4 and 5.

The material aluminum does not form nanostructures with a desired helical shape at substrate temperatures Ts of 300K and 253K, but forms nanostructures with a desired, clear helical shape at a substrate temperature Ts of 233K. The resulting nanostructures have a diameter of about 20 nm at the bottom portion, where the diameter less increases with growth. The material aluminum has a melting point of 933K, and the ratio of the substrate temperature Ts of 233K at which the material gives nanostructures with a desired, clear helical shape to the melting point is 0.25.

The material nickel begins forming nanostructures with a helical shape at a substrate temperature Ts of 453K in the nickel nanostructures according to the first embodiment. The material copper begins forming nanostructures with a helical shape at a substrate temperature Ts of 323K in the copper nanostructures according to the second embodiment. The material aluminum begins forming nanostructures with a helical shape at a substrate temperature Ts of 253K in the aluminum nanostructures according to the third embodiment. These demonstrate that the substrate temperature to be controlled varies from a material to another. In contrast, the ratio of the substrate temperature Ts at which the material begins forming nanoscale microstructures with a helical shape to the material melting point is 0.26 in the nickel nanostructures according to the first embodiment. The ratio of the substrate temperature Ts at which the material begins forming nanoscale microstructures with a helical shape to the material melting point is 0.25 in the copper nanostructures according to the second embodiment. The ratio of the substrate temperature Ts at which the material begins forming nanoscale microstructures with a helical shape to the material melting point is 0.25 in the aluminum nanostructures according to the third embodiment. These demonstrate that the substrate temperature may be controlled so as to give an approximately same ratio of the substrate temperature to the material melting point regardless of the kind of the material.

As described above, the third embodiment controls the absolute temperature of the substrate 31 to be equal to or lower than 0.25 time the melting point (absolute temperature) of aluminum, where aluminum is a main material for nanostructures. The control can give fine nanostructures that have a wire diameter of less than 100 nm and have a desired helical shape. The substrate structure according to the third embodiment includes fine nanostructures having a wire diameter of less than 100 nm and including aluminum, where aluminum has a relatively low melting point and is industrially useful. The substrate structure is thereby applicable to a variety of industrial areas such as electronic devices.

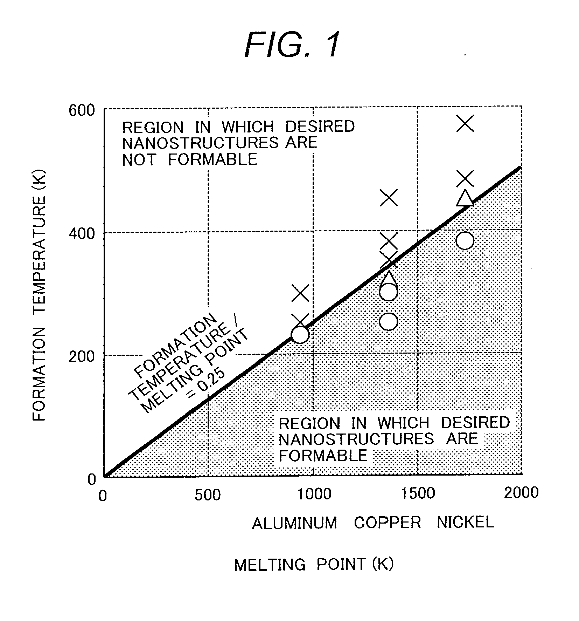

Fig. 1 illustrates the relationship between the melting point of the main material for nanostructures and the formation temperature (corresponding to the substrate temperature) of the nanostructures. Fig. 1 is a graph plotted with the abscissa indicating the melting point of the main material and with the ordinate indicating the substrate temperature upon formation according to the first, second, and third embodiments. A condition under which a clear helical shape is formed is indicated with an open circle; a condition under which a clear helical shape is not formed is indicated with a cross; and a condition under which an approximately helical shape is formed is indicated with an open triangle. Fig. 1 also depicts a relational expression at a ratio of the formation temperature to the melting point of 0.25. Fig. 1 demonstrates that any of the materials can form nanostructures with a clear helical shape or an approximately helical shape at a ratio of the formation temperature to the melting point of equal to or less than 0.25. Accordingly, fine nanostructures having a diameter of less than 100 nm and having a desired shape can be produced from a main material having any melting point, as long as the production meets the condition that "the ratio of the formation temperature to the melting point is equal to or less than 0.25". In this connection, the atom 33 is deposited on the substrate 31 to form the nanostructure nuclei in the early stages of the formation and is further deposited on the surface of the nuclei including the deposited atom 33 to form the nanostructures, as described above. To form the nuclei, the substrate temperature may be controlled to be equal to or higher than such a temperature as to allow the atom 33 to have sufficient energy to form the nanostructure nuclei on the substrate 31.

### Fourth Embodiment

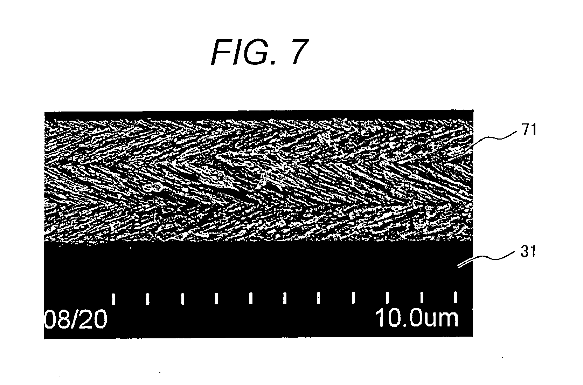

Fig. 7 illustrates nanostructures according to the fourth embodiment of the present invention. The fourth embodiment differs from the first, second, and third embodiments in that the nanostructures according to the fourth embodiment have not a helical shape, but a zigzag shape or a polygonal-line shape. The zigzag shape and the polygonal-line shape are hereinafter also simply referred to as a "zigzag shape". The nanostructures according to the fourth embodiment use copper as the main material.

The zigzag nanostructures can have shorter distances from adjacent nanostructures and can be disposed in a larger number per unit area as compared with the helical nanostructures. In contrast, the zigzag nanostructures are more geometrically anisotropic in the in-plane direction in the layer of the nanostructures as compared with the helical nanostructures. In consideration of the geometrical anisotropy (geometrical difference), the nanostructures can be applied to various uses by selecting the shape of the nanostructures from various structures including the zigzag shape in the fourth embodiment.

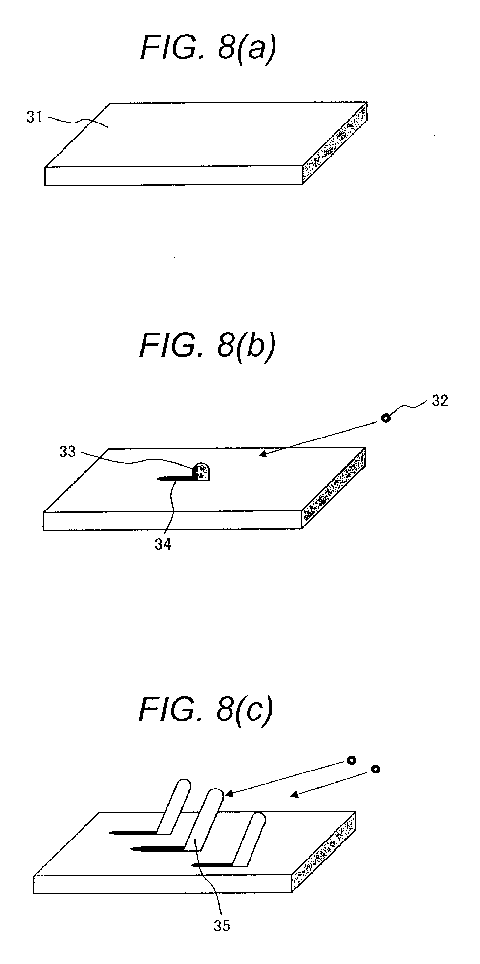

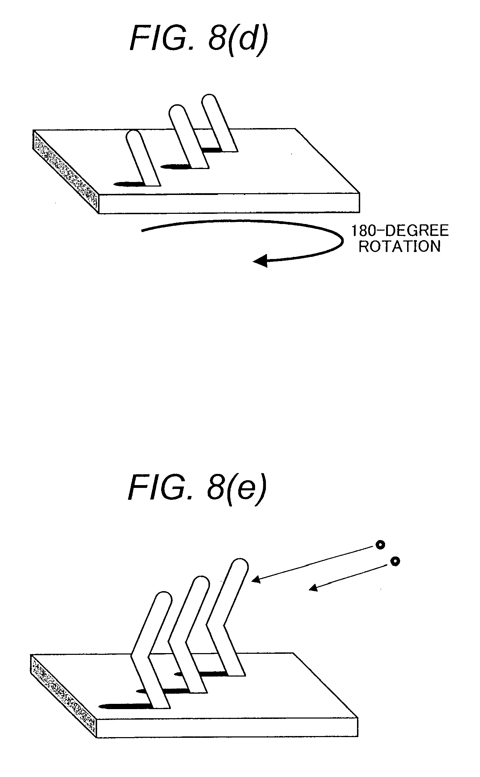

Figs. 8A, 8B, 8C, 8D, and 8E illustrate a method for producing the nanostructures according to the fourth embodiment of the present invention.

A substrate 31 having a flat surface (Fig. 8A) is secured to the stage 7 of the dynamic oblique deposition apparatus (Fig. 2). An atom 32 is applied to and deposited on the surface of the substrate 31 from an oblique direction at a certain angle. The atom 33 is deposited on the surface of the substrate 31 and casts a shadow 34 cast by the deposited atom (Fig. 8B), as in the production method according to the first embodiment. Once the shadow 34 cast by the atom is formed, the atom 32 is not deposited in a region corresponding to the shadow 34 cast by the deposited atom, but is deposited on the surface of the deposited atom 33 alone. The evaporated atom 32 is deposited to form oblique columns 35 (Fig. 8C). In the production method according to the first embodiment, the atom 32 is deposited while the stage 7 is rotated in-plane at a constant speed. In contrast, in the production method according to the fourth embodiment, the atom 32 is deposited to form nanoscale oblique columns while the stage 7 is secured. Thereafter, the stage 7 is rotated in-plane 180 degrees (Fig. 8D) and is secured again. As a result of the rotation, oblique columns are grown toward a different direction from the nanoscale oblique columns (Fig. 8E). Repetition of this process can give zigzag, self-standing nanostructures. Control of the stage angle and/or the rotation time in this process can give nanostructures with any zigzag shape.

### Fifth Embodiment

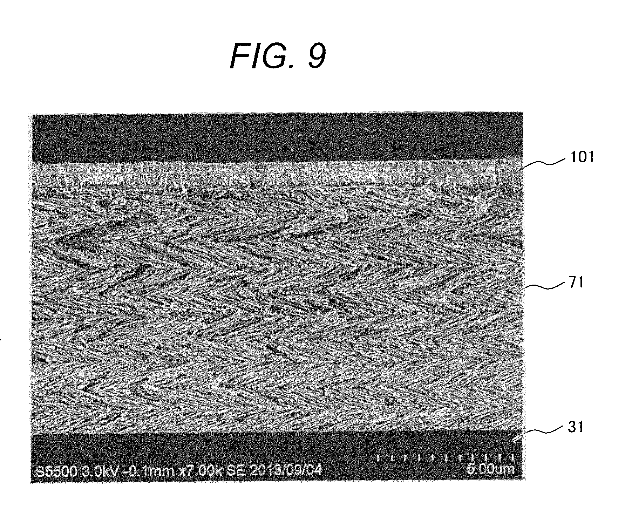

Fig. 9 illustrates nanostructures according to the fifth embodiment of the present invention. The fifth embodiment differs from the first, second, third, and fourth embodiments as follows. The nanostructures according to the fifth embodiment include not only a layer of nanostructures disposed on the surface of a substrate 31, but also a planar layer 101 disposed on top surfaces of the nanostructures.

The nanostructures 71 in the fifth embodiment use copper as a main material and have a zigzag shape. The planar layer 101 uses nickel as a main material and has a thickness of about 0.8 µm. The planar layer 101 prevents the nanostructures 71 from being exposed to the surface and can protect the nanostructures 71.

The main material for the planar layer 101 may be selected as appropriate according to an intended purpose such as the protection of the nanostructures 71. The main material for the planar layer 101 may be a material identical to, or different from, the main material for the nanostructures. For example, assume that the planar layer 101 is formed from a main material identical to the main material for the nanostructures 71. In this case, another layer of nanostructures 71 can be formed on the planar layer 101. This allows the layers of the nanostructures 71 to have an approximately larger thickness. Assume that another member (component) is bonded or adhered to the top of the nanostructures 71. In this case, the planar layer 101 may use, as a main material, a material that has good bondability or adhesiveness with the other member (component). Such good bondability or adhesiveness eases the bonding or adhesion between the nanostructures 71 and the other member and increases the reliability of the bonding or adhesion.

Apluralityof planar layers 101 may be formed from different main materials. For example in an embodiment, a first planar layer to be in contact with the top surface of the nanostructures is formed from a main material that has good adhesiveness with the nanostructures. In addition, a second planar layer is formed on the first planar layer from a main material that has good adhesiveness with the first planar layer and with the other member. This allows the other member to be adhered onto the nanostructures with good reliability, even when the other member includes a main material that has low adhesiveness with the nanostructures.

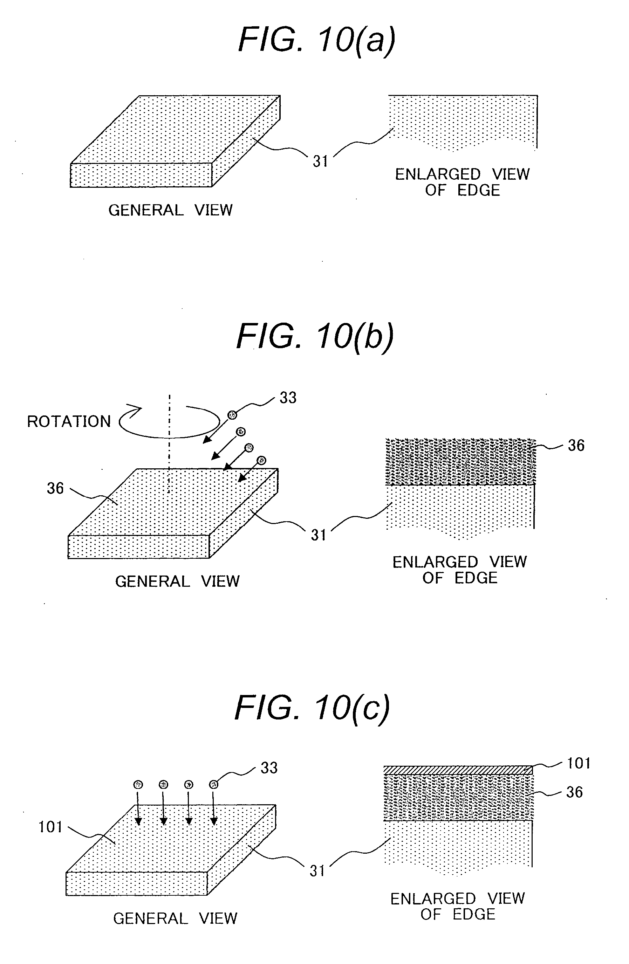

Figs. 10A, 10B, 10C, 10D, and 10E illustrate a method for producing the nanostructures according to the fifth embodiment. In the production method according to the fifth embodiment, a substrate 31 is prepared (Fig. 10A), and a layer of nanostructures 36 is formed on the surface of the substrate 31 by dynamic oblique deposition (Fig. 10B), as with the first, second, third, and forth embodiments. Although the nanostructures 36 illustrated in Fig. 10B have a helical shape, the nanostructures to be formed herein may have any shape such as the zigzag-shape in the nanostructures 71 (Fig. 9). Next, an atom 33 is evaporated toward the front surface of the substrate 31 without the rotation of the substrate 31 (Fig. 10C). The atom 33 is deposited on the top edges of the nanostructures. This connects the top edges of adjacent nanostructures to each other. The vapor deposition procedure is further continued to form the planar layer 101.

The planar layer 101 may be formed using the production apparatus illustrated in Fig. 2, or using another production apparatus. The production apparatus illustrated in Fig. 2, when used not only for the formation of the nanostructures, but also for the formation of the planar layer 101, contributes to better production efficiency. This is because the planar layer 101 in this case may be formed by setting the main material again in the crucible and operating the same production apparatus as in the formation of the nanostructures. In an embodiment, the planar layer is formed from a main material identical to the main material for the nanostructures. This contributes to still better production efficiency. This is because the planar layer can be formed using the same material set in the crucible to form the nanostructures by operating the same production apparatus as in the formation of the nanostructures without setting another main material.

### Sixth Embodiment

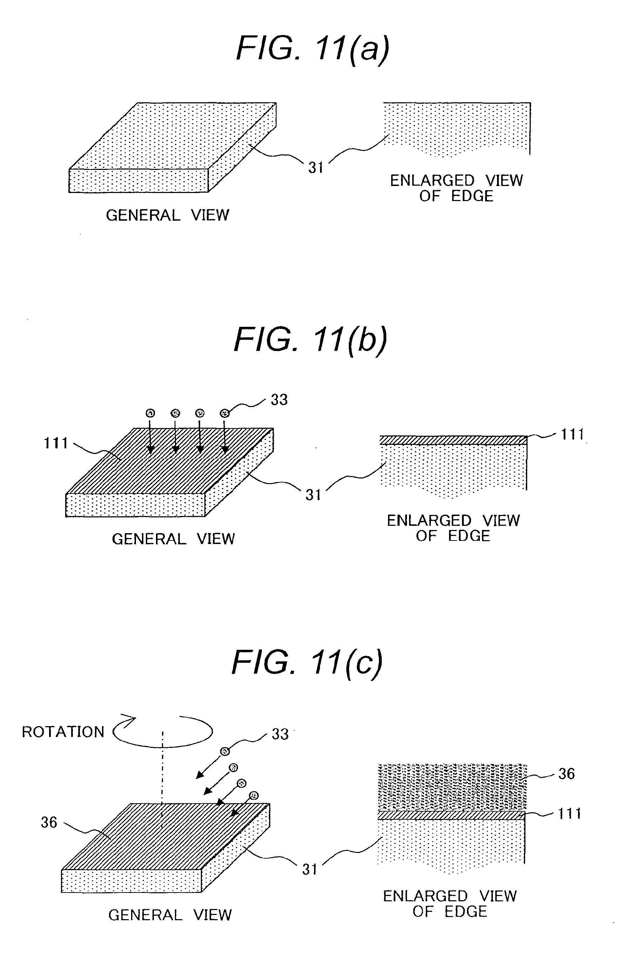

Figs. 11A, 11B, and 11C illustrate nanostructures, and a production method of the nanostructures, according to the sixth embodiment of the present invention. The sixth embodiment differs from the first, second, third, fourth, and fifth embodiments in that the nanostructures are disposed not directly on the surface of a substrate 31, but disposed on a substrate surface layer 111 which has been disposed on the surface of the substrate 31.

Specifically, an atom 33 is evaporated onto a surface of the substrate 31 (Fig. 11A) to form the substrate surface layer 111 (Fig. 11B). Next, a layer of nanostructures 36 is formed by dynamic oblique deposition (Fig. 11C). The nanostructures 36 illustrated in Fig. 11C have a helical shape. However, nanostructures having any shape, such as the zigzag nanostructures according to the fourth embodiment (Fig. 7), can be employed as the nanostructures 36.

Assume that the substrate surface layer 111 in the sixth embodiment is formed from a main material identical to the main material for the nanostructures. In this case, the substrate 31 is bonded to the nanostructures 36 with an approximately larger bonding area. This allows the substrate 31 and the nanostructures 36 to be bonded to each other with better bonding reliability. Further assume that the substrate surface layer 111 is formed from a main material different from the main material for the nanostructures. Even in this case, the substrate 31 can be bonded to the nanostructures 36 with better bonding reliability by using a main material selected from materials that have good bondability both with the substrate 31 and with the nanostructures 36. A plurality of substrate surface layers 111 may be disposed as with the planar layer in the fifth embodiment.

### Seventh Embodiment

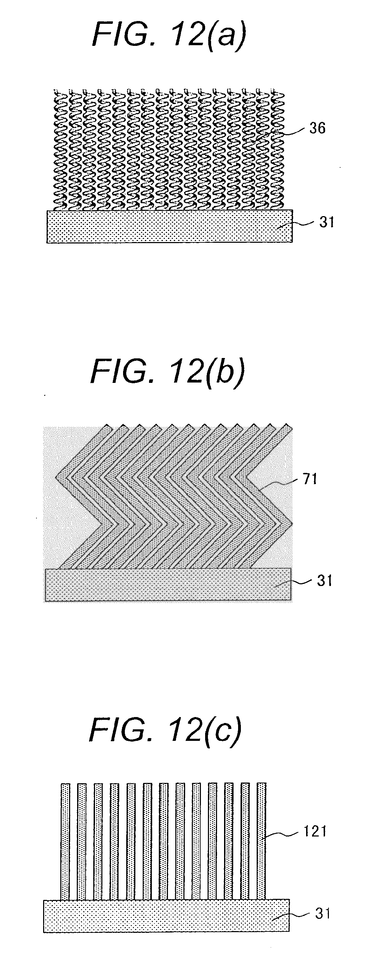

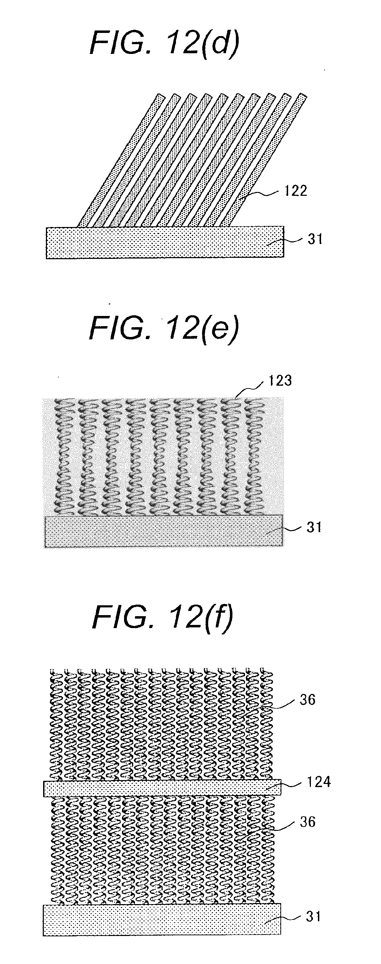

Figs. 12A, 12B, 12C, 12D, 12E, and 12F illustrate a variety of shapes of nanostructures according to a seventh embodiment of the present invention.

Fig. 12A illustrates the helical nanostructures according to the first, second, and third embodiments.

Fig. 12B illustrates the zigzag nanostructures according to the fourth embodiment.

Fig. 12C illustrates columnar, self-standing nanostructures disposed vertically on the substrate 31. The nanostructures illustrated in Fig. 12C can be produced by the production method according to the first embodiment (see Fig. 3) in which the stage 7 is rotated at a high speed to form a helical with a small outer diameter.

Fig. 12D illustrates oblique columnar, self-standing nanostructures disposed vertically on the substrate 31. The nanostructures illustrated in Fig. 12D can be produced by the production method according to the first embodiment or the fourth embodiment (see Fig. 3 or 8), except for not rotating the stage 7.

Fig. 12E illustrates helical, self-standing nanostructures disposed vertically on the substrate 31, where the nanostructures each have a helical diameter varying in dimension along the thickness direction. The nanostructures illustrated in Fig. 12E can be produced by the production method according to the first embodiment, except for changing the rotation speed of the stage 7 with the growth of the nanostructures.

Fig. 12F illustrates nanostructures including a plurality of layers of nanostructures in the thickness direction. The nanostructures illustrated in Fig. 12F can be produced by the production method according to the fifth embodiment (see Figs. 11A, 11B, and 11C). Specifically, the nanostructures can be formed by forming a first layer of nanostructures 36 and a planar layer 124 sequentially on a substrate 31, and further forming a second layer of nanostructures 36 on the planar layer 124 constituting a surface by dynamic oblique deposition. This can give two layers of nanostructures, where the two layers are stacked through the planar layer 124. The planar layer 124 acts as an intermediate layer. Three or more layers of nanostructures can be formed by repeating the production process as above. This allows the layers of nanostructures to have an approximately larger total thickness.

As described above, the dynamic oblique deposition in the embodiments can give nanostructures having a shape selected from not only the shapes illustrated in Figs. 12A, 12B, 12C, 12D, 12E, and 12F, but also a variety of other shapes.

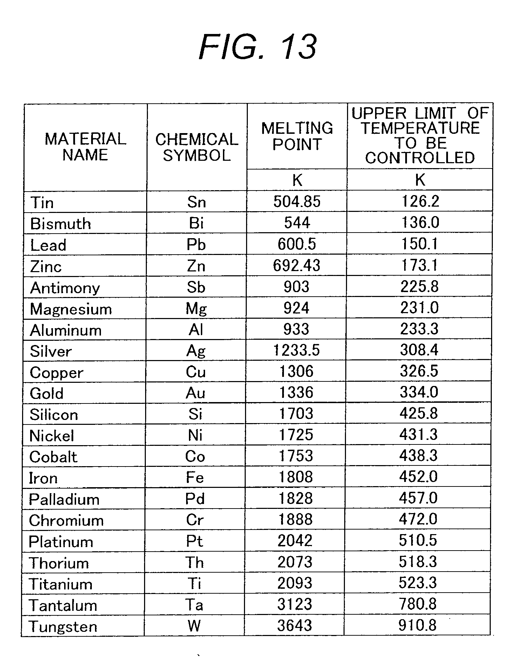

Fig. 13 illustrates melting points (absolute temperatures) of major materials; and upper limits of substrate temperatures (absolute temperatures) to be controlled at which fine nanostructures having a diameter of less than 100 nm and having a desired shape can be formed from the materials. The melting point and the substrate temperature to be controlled to obtain advantageous effects of the present invention vary from a material to another. However, conditions for producing nanostructures from any material can be determined by controlling the substrate temperature to be equal to or lower than 0.25 time the melting point of the material, as revealed in the present invention. Fig. 13 illustrates a list of a variety of materials. Even another material not described in the list, however, can give nanostructures by controlling the substrate temperature to be equal to or lower than 0.25 time the melting point of the material, as revealed in the present invention.

The present invention is not limited to the specific embodiments, but includes various modifications. For example, the embodiments have been described in detail so as to illustrate the present invention comprehensibly. The present invention is not always limited to embodiments each including all the described configurations. It is also possible to add, delete, and/or replace part of the configuration of an embodiment with another configuration.

## Claims

1. A method for producing nanostructures (36; 71), comprising the step of
a) evaporating a main material for the nanostructures (36; 71) onto a flat surface of a substrate (31) to form a plurality of the nanostructures (36; 71) on or over the flat surface of the substrate (31),
wherein the substrate (31) in the step a) is controlled to have an absolute temperature equal to or lower than 0.25 times a melting point (absolute temperature) of the main material.

2. The method of claim 1, wherein the nanostructures (36; 71) each have a diameter of less than 100 nm.

3. The method of claim 1 or 2, wherein the substrate (31) is rotated in the step a).

4. The method of any preceding claim, comprising the step of
b) evaporating a predetermined material onto the plurality of nanostructures (36; 71) from the step a) so as to form a planar layer (101; 124) on a top of the plurality of nanostructures (36),
wherein the substrate (31) is preferably not rotated in the step b).

5. The method of any preceding claim, comprising the step of
c) evaporating a predetermined material onto the flat surface of the substrate (31) so as to form a substrate surface layer (111) on the flat surface of the substrate (31), the step c) being performed before the step a),
wherein the substrate (31) is preferably not rotated in the step c).

6. An apparatus for producing nanostructures (36; 71), comprising:
a vacuum chamber (1) in which the nanostructures (36; 71) are to be formed;
a crucible (2) in which a material (4) is to be placed, where the crucible (2) is disposed in the vacuum chamber (1);
an electron gun (3) disposed in the vacuum chamber (1), where the electron gun (3) is configured to apply electron beams (5) to the material (4) in the crucible (2) so as to evaporate the material (4);
a stage (7) disposed in the vacuum chamber (1) so as to face the crucible (2), where the stage (7) bears a member on or over which the evaporated material (4) is to be deposited, and where the stage (7) is pivotally supported and is arranged so as to face the crucible (2) at a variable angle;
a cooling unit (8) for cooling the stage (7);
a heating unit (9) for heating the stage (7);
a temperature sensor (10) for detecting a temperature of the stage (7); and
a controller (11) for operating the cooling unit (8) and the heating unit (9) based on the temperature detected by the temperature sensor (10) so as to control the temperature of the stage (7).

7. The apparatus of claim 6, wherein the controller (11) is adapted to control an absolute temperature of the stage (7) so that the absolute temperature is equal to or lower than 0.25 times a melting point (absolute temperature) of the material.

8. The apparatus of claim 6 or 7, wherein the cooling unit (8) is adapted to use liquid nitrogen as a coolant.

9. A nanostructure-containing substrate structure comprising:
a substrate (31) having a flat surface; and
a plurality of nanostructures (36; 71) disposed vertically on or over the flat surface of the substrate (31),
the plurality of nanostructures (36; 71) each having a diameter of less than 100 nm, and
the plurality of nanostructures (36; 71) comprising a main material having a melting point equal to or lower than a melting point of copper.

10. The substrate structure of claim 9, wherein the plurality of nanostructures (36; 71) have at least one shape selected from the group consisting of:
helical shapes;
zigzag shapes;
columnar shapes; and
oblique columnar shapes.

11. The substrate structure of claim 9 or 10, comprising;
a planar layer (101; 124) on a top of the plurality of nanostructures (36); and
optionally a plurality of second nanostructures (36) disposed vertically on or over the planar layer (124).

12. The method of claim 4, or the substrate structure of claim 11, wherein the planar layer (101; 124) is formed by a material identical to the main material constituting the plurality of nanostructures (36).

13. The substrate structure of any of claims 9 to 12, comprising a substrate surface layer (111) disposed between the flat surface of the substrate (31) and the nanostructures (36).

14. The method of claim 5, or the substrate structure of claim 13, wherein the substrate surface layer (111) is formed by a material identical to the main material of the nanostructures (36).

15. The substrate structure of claim 13, wherein the substrate surface layer (111) comprises a material different from the main material constituting the nanostructures (36).
